# EUROPEAN PATENT APPLICATION

(11) **EP 2 857 192 A1**
(43) Date of publication of application: **08.04.2015**
(21) Application number: 13187207.9
(22) Date of filing: 03.10.2013
(51) Int. Cl.: B32B 17/00, H03K 17/96

(54) **Glass having integrated switching device**

(71) Applicant: AGC Glass Europe, 1348 Louvain-la-Neuve (BE)
(72) Inventor: Cumpelik, Pavel, 417 42 Krupka (CZ)
(74) Representative: Larangé, Françoise

(57) **Abstract**

Integrated touch sensitive device having a visual user feedback and being attached to a circular opening made in a sheet of glass, wherein this device is connected for communication and power supply purposes to a system external to the glass sheet, by thin wires invisible to naked eye and having low resistivity to allow power supply and data communication over large distance.

## Description

The present invention relates to a sheet of laminated safety glass having a replaceable, preferably circular, switching device integrated therein, inserted into a preferably circular opening made in one or more of the glass layers. This device is equipped by electronic component including touch sensitive glass, OLED or LED light source and driving electronics and power supply. Advantageously, the switch has no mechanical moving parts and is designed to created seamless protrusive or intrusive shape allowing easy recognition of such device to people with certain sensory disability. Touchable part is made of glass, is preferably transparent and has advantageously spherical shape which may provide certain magnification of the information displayed behind it. Such information may be for example luminous signal or other visual information created by light source or another display technology. The switch is located in the opening which is not connected to the edge of the glass, while power supply and communication connection are made of thin conductive wires, not visible to naked eye from a short distance. Such connection between the opening and edge of the glass is protected by surface sheet of glass and is usually integrated into the interlayer of safety glass. The switch device is attached to the substrate glass by means of a removable fixing device, e.g. an adhesive joint or by magnetic system. Easy extraction of the switch for its replacement is possible during its production and entire service life.

Switches integrated into laminated safety glass usually combine power supply and data communication flow via thin coating with high sheet resistance which limits the maximum distance of the device from the edge of the glass. Prior art switches integrated to glass are attached to the surface of glass or are installed inside of its structure in a way, that any replacement *per partes* is impossible and the entire system must be replaced, which is difficult and costly. That is valid during both production process and service life of the system.

In addition, switches integrated under the surface of glass having no protrusive or intrusive shape cannot be detected easily by people with certain sensory disability.

One of the most important architectural trends over the last period is to improve transparency of the building structures, such as interior partitions, walls and building envelopes. The main goal is to achieve better aesthetics, improve natural illumination of the building interior and visual comfort. The glass is commonly used for such applications due to its transparency, high structural capacity and perfect aesthetics. Required higher level of transparency brings several technical challenges such as integration of usual building control systems, for example lighting switches, transport system controls, HVAC, shading devices, switchable glass and others. The presence of visible wires is usually not appreciated and there is a need to hide them or make it invisible to the naked eye. Another challenge is to integrate control devices in a way that allows reasonable maintenance such as replacement of electric and electronic parts and other functional components.

Prior art is based on using a conductive and transparent surface coating layer deposited on glass during its manufacturing. This coating is used for data and power transfer but has some important limitations, more specifically its electrical resistivity and presence over the entire surface of the glass. It is indeed transparent, but usually has different colour and reflection than the naked glass, which in fact is problematic for many architects and designers. To create functional electrical circuit, it is necessary to make a conductive pattern by cutting the coating especially in the case where such coating is designed to have a functionality of touch sensor. Laser treatment or coating deposition with a mask on the surface are common techniques to achieve that. Due to the relatively high sheet resistance of the coating it is difficult to maintain efficient power supply and data signal quality over longer distances. It is especially the case when using sensors, CPUs and other electronic parts which are positioned far from the edge of the glass. Another problem is that such technology allows only fully integrated design of the glass where all parts are permanently attached to the glass. However glass has significantly longer lifetime and higher durability than the other functional components of the system, and in case of failure of a single component, the whole system must be replaced without possibility to repair it on site. Additionally such glass is usually very heavy and such replacement is thus very costly and time consuming.

It is important to add that the described integrated concept of the prior art requires highly specialized, integrated and complex industrial process. That means such technology requires significant investment and thus is not broadly accessible. Such industrial process for fully integrated glass with electronics is also problematic from the perspective of process efficiency and production yield. It often happens that an individual defect found at the end of the process makes the product unusable because there is no way for repairing such defect. It is especially important for large glasses having large number of electrically powered components which are usually costly and wherein a single defect found results in wasting all other functional parts too.

Regarding functionality of said fully integrated glasses there is also another problem linked to the generally used flatness of the glass surface. Indeed people with sensory disability cannot find easily the functional device hidden under the glass surface which in fact limits the application of those systems especially in public buildings.

Problems of prior art are thus mainly:
- distance limitation between edge of the glass and location of the electronic device due to high resistivity of the conductive coating on glass;
- problematic aesthetics due to colour / reflection difference between adjacent naked and coated glass placed in the same structure;
- inefficient maintenance without possible repair on site, requiring heavy equipment and limiting the use of the related building interior space;
- limited access to technology due to complex industrial process linked to significant investment yield aspect;
- high costs of glazing replacement and maintenance resulting in limited use of the space;
- problematic use by people with sensory disability resulting in narrowed field of applications, especially with regard to public space.

The invention solves the problem of distance limitation between the device and the edge of the glass by using an alternative conductive system, which consists of multiple thin wires netted into the laminated glass interlayer, i.e. provided as a thin wires network into the interlayer. The resistance of those wires is much lower than the resistance of coatings used by prior art solutions; so the voltage drop on a long distance is much lower or even negligible for most of electric and electronic devices. That allows to place driving electronics and powered functional devices far from the edge of the glass.

Due to the fact that the invention does not comprise any conductive coating on the glass, the problem of different colour (both in reflection and transmission) disappears completely. Additional advantage is that any glass substrate can be used without limitation, for example glass of various colours, glass having undergone various functional treatments like acid etching treatments, thermal or chemical toughening treatments, decorative painted glass, and glass having any thickness.

The functional electronic device is firmly attached to the opening in the sheet of glass by means of a removable fixing device, such as a dismountable joint, for example an adhesive joint, or a magnetic system. That concept allows to extract individual components in case of system failure and replace those parts by functional ones. Such a repair is much less difficult and costly than replacement of fully integrated glass like in prior art cases. Additionally it does not require temporary glazing solution to be put in place for safety reasons whilst the defected glass is taken out for repair. The opening in the glass is usually circular, which shape corresponds to most common technique of glass drilling, which is less costly and easier than creating any other shape of opening in the glass. Preferably, the opening is passing through one or more sheets of the laminated glass in a way that one glass sheet remains intact and provides support for placing the device.

The problem of inefficient industrial process related to prior art is solved by splitting industrial process into several independent procedures. In an advantageous embodiment of the invention, the first procedure is the assembly of the laminated safety glass with opening by means of a polymeric interlayer (e.g. PVB) including wires which have been previously incorporated therein, for example by a kind of sewing method, wherein a sewing machine is used and a needle with the wire goes through the interlayer. Apart of that, the electronic device containing touch cover glass, touch sensitive glass with coating, display component, driving electronics and connection interface is assembled and attached to its generally cylindrical housing to create one integrated insert which fits firmly into the opening of the laminated safety glass. By splitting the industrial process, individual yields of each procedure has no direct influence on the quality and yield of the final product and thus each procedure can be optimized separately. It is also possible to replace or repair some parts during manufacturing process while maintaining the others. This has a positive direct impact on production costs and yield.

Maintenance of the system is much easier than in prior art cases due to the fact that some functional components can be easily replaced and there is no need to remove the entire laminated safety glass panel, which is usually very heavy and costly. By this easy replacement the owner's costs are significantly reduced when considering entire service life of the glazing being much longer than of any electronic device. Additionally, this easy replacement means also possible hardware upgrades of the system.

The problem of prior art solution linked to users with certain sensory disability is solved by the invention, because preferably protrusive or intrusive shape of the cover glass makes it very well recognizable by touching. When information available for the user is provided as a background of the device (herein called "display information feedback", such as lighting on OLED or LED or another display information) it is magnified by generally spherical shape of the cover glass and thus more user friendly, especially for people with certain sensory disability. This makes the invention suitable for use in public spaces where it is essential to provide such friendly and barrier-free user interface.

The invention thus also relates to placing interactive touch sensitive device combined with display information into the circular opening made in the sheet of the glass, which is preferably a laminated safety glazing. This device is connected to the circuit external to the glass sheet via multiple highly conductive wires located inside of the laminate. Those wires allows to power or communicate with the cited device and have a low resistance which ensures sufficient quality of signal and power supply to the device. The device may basically be a switch, either binary or more sophisticated switching system.

The cited device preferably comprises various integrated components, more specifically the transparent or translucent cover glass of generally spherical shape and providing seamless joint with the opening on the user side, touch sensitive device, display or illumination device, driving electronics and connection means. It is designed to provide touch interface, preferably with visual information feedback for the user. In an advantageous embodiment, the cover glass has a stepped geometry allowing to insert it firmly into the opening and create an overlap region on the glass surface where the two components meet each other with an angle such that it ensures the smooth and seamless look and feel.

Under this cover glass, the touch sensitive sheet of material, e.g. glass is placed. This touch sensitive layer is preferably transparent and translucent to allow passing light from the illumination or display devices installed under it.

Advantageously, the cited integrated device has a housing of generally cylindrical shape which is equipped with connections pads at its bottom face, allowing for example dry spring connection of the device when the insert is put in place. To keep reliable electric contact and at the same time be able to separate the device from the opening in case of replacement or maintenance, a magnetic system on the bottom of housing and its counterpart on the bottom of the opening may be used. This magnetic system may be designed in such a way that magnetic force of the system can be deactivated by third magnet with adequate polarity and strength. Due to the need of firm connection of the device to the opening, strong magnets e.g. neodymium ones are preferably used. Connection pads and housing connection are advantageously connected to each other by at least one spring metallic component for maintaining pressure between the two connected parts.

The cited integrated device preferably comprises the following parts, creating a specific sequence of components, where some are essential and some are optional. The sequence listed from user side is as follows:
- Cover glass
- Optically clear adhesive layer (optional)
- Touch sensitive layer
- Optically clear adhesive layer (optional)
- Optical filter (optional)
- Display or other illumination device with low dissipative heat emission, e.g. SSL lighting
- Driving electronics and accessories
- Generally cylindrical housing, where all components are mechanically fixed
- Electrical connection system
- Magnetic system or adhesive joint to fix the housing to the opening

The main application of the present invention is as glass-integrated touch sensitive switch device with visual feedback and optional content display dedicated to use in interiors of buildings, furniture, transportation and home appliances. Some examples of applications can be listed as follows:
- glass partitions
- glass sheet wall cladding
- balustrades
- facades, windows and doors
- car windows and interior glass covers
- train interior glazing
- shop windows
- active glass system such as switchable glass or glass with integrated shading system
- microwave ovens, interactive tables,

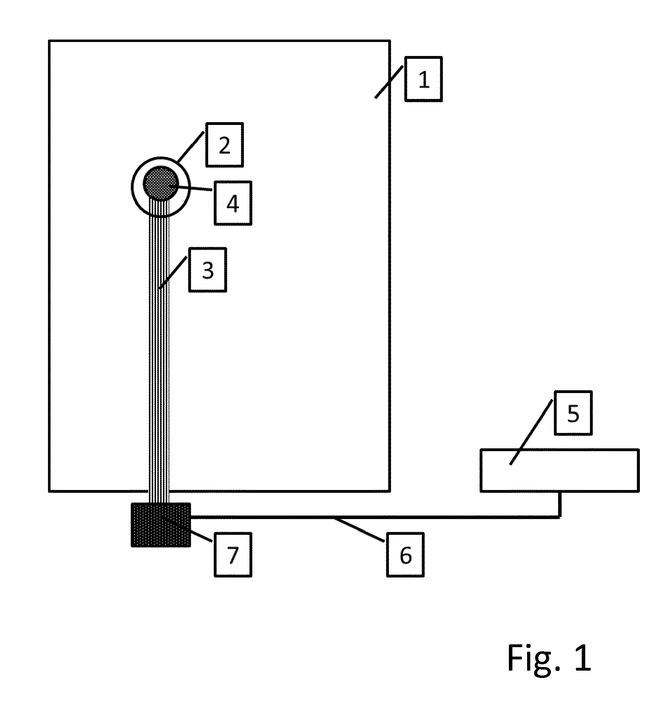

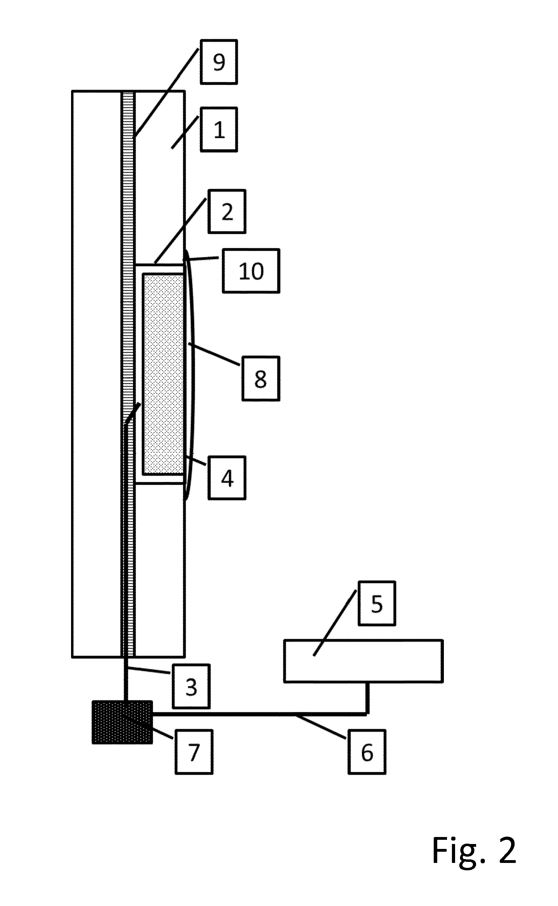

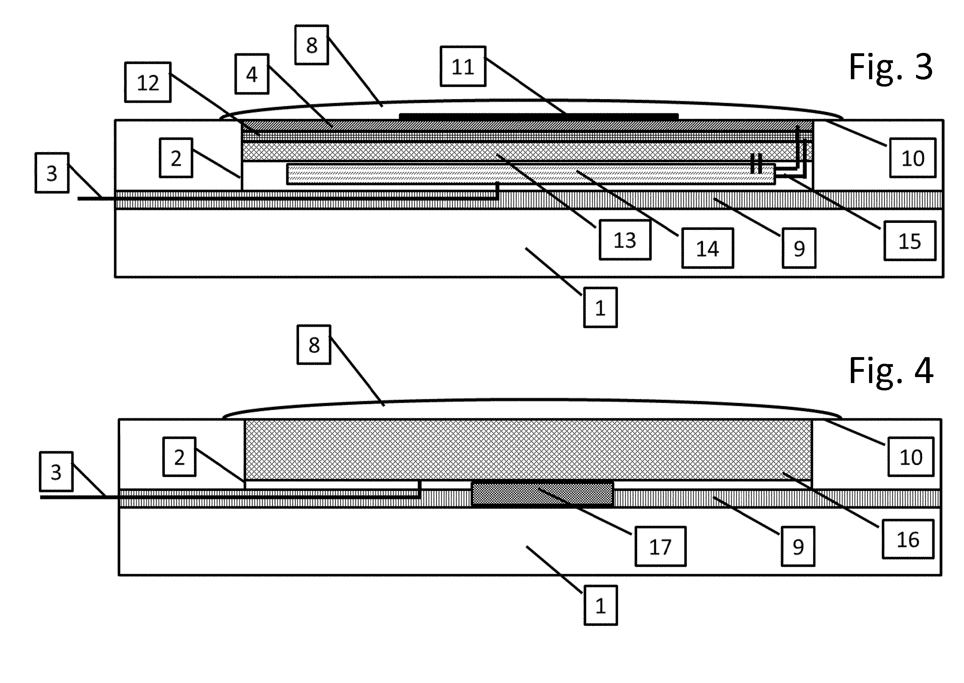

Embodiments of the invention are exemplified in Figures 1 to 4, wherein same numerals indicate similar components, according to the following numbering:
1. Laminated safety glass
2. Opening passing through one or multiple glass sheets
3. Multiple wired connection dedicated to communication and power supply
4. Integrated touch sensitive insert unit
5. Building power supply and data processing system
6. Power and communication wiring
7. Standardized bus
8. Protrusive glass cover cap of generally spherical shape
9. Common safety glass interlayer, such as thermoplastic
10. Overlap for seamless joint

## Claims

1. Laminated glazing panel comprising at least two sheets of glass and a laminating interlayer, wherein at least one of the glass sheets incorporates an opening, said laminated glazing panel further comprising an integrated touch sensitive device being attached to said opening in a removable way and being connected for communication and power supply purposes to a system external to the glazing panel, by thin wires invisible to naked eye, having low resistivity to allow power supply and data communication over large distance, and being incorporated into the laminating interlayer.

2. Glazing panel as claimed in claim 1, wherein the opening is substantially circular.

3. Glazing panel as claimed in claim 1 or claim 2, wherein the integrated touch sensitive device comprises a visual user feedback.

4. Glazing panel as claimed in claim 3, wherein the visual feedback is achieved by placing OLED, LED or display under a transparent glass cover having preferably a substantially spherical shape.

5. Glazing panel as claimed in any preceding claims, wherein the integrated device is attached to the opening by an adhesive joint or by a magnetic system which can be deactivated by another magnetic system in case of maintenance or replacement.

6. Glazing panel as claimed in any preceding claims, comprising, in sequence from user side:
- Cover glass
- Optically clear adhesive layer (optional)
- Touch sensitive layer
- Optically clear adhesive layer (optional)
- Optical filter (optional)
- Display or other illumination device with low dissipative heat emission, e.g. SSL lighting
- Driving electronics and accessories
- Generally cylindrical housing, where all components are mechanically fixed
- Electrical connection system
- Magnetic system or adhesive joint to fix the housing to the opening.

7. Glazing panel as claimed in claim 6, wherein cover glass, touch sensitive layer, and optional optical filter layer are transparent or translucent to achieve illumination from display or SSL located under it.

8. Glazing panel as claimed in any preceding claims, wherein the laminating interlayer is selected from the group consisting of PVB, EVA , resin and ionoplast interlayers.

9. Glazing panel as claimed in any preceding claims, wherein at least one of the glass sheet includes at least one coating or paint layer providing other functionalities such as aesthetics, solar control, fire protection.
